# EUROPÄISCHE PATENTANMELDUNG

(11) **EP 3 236 572 A1**
(43) Veröffentlichungstag der Anmeldung: **25.10.2017**
(21) Anmeldenummer: 17166987.2
(22) Anmeldetag: 19.04.2017
(51) Int. Cl.: H02M 1/34, H03K 17/081, H03K 17/0814

(54) **LEISTUNGSELEKTRONISCHE SCHALTZELLE SOWIE UMRICHTERSCHALTUNG MIT SOLCHEN SCHALTZELLEN**

(30) Priorität: 19.04.2016 EP 16166024
(71) Anmelder: ABB Schweiz AG, 5400 Baden (CH)
(72) Erfinder: SCHWEIZER, Mario, 8057 Zürich (CH); Steimer, Peter, 5420 Ehrendingen (CH); Vemulapati, Umamaheswara, 5430 Wettingen (CH)
(74) Vertreter: ABB Patent Attorneys

(57) **Zusammenfassung**

Eine Leistungselektronische Schaltzelle umfasst einen ersten ansteuerbaren bidirektionalen Leistungshalbleiterschalter (1) mit gesteuerter unidirektionaler Stromführungsrichtung, und mit einem Stromanstiegsbegrenzungsnetzwerk (4), wobei der erste Leistungshalbleiterschalter (1) eine erste Diode (3) aufweist, die antiparallel zur gesteuerten unidirektionalen Stromführungsrichtung des ersten Leistungshalbleiter-schalters (1) angeordnet ist, wobei das Stromanstiegsbegrenzungsnetzwerk (4) parallel zu dem ersten Leistungshalbleiterschalter (1) geschaltet ist, wobei das Stromanstiegsbegrenzungsnetzwerk (4) eine Serienschaltung aus einem zweiten ansteuerbaren bidirektionalen Leistungshalbleiterschalter (6) mit gesteuerter unidirektionaler Stromführungsrichtung, einem Widerstand (7) und einer Kapazität (8) aufweist, wobei der zweite Leistungshalbleiterschalter (6) eine zweite Diode (10) aufweist, die anti-parallel zur gesteuerten unidirektionalen Stromführungsrichtung des zweiten Leistungshalbleiterschalters (6) angeordnet ist, wobei der zweite Leistungshalbleiterschalter (6) antiparallel zu dem ersten Leistungshalbleiterschalter (1) angeordnet ist, so dass die gesteuerte unidirektionale Stromführungsrichtung des ersten Leistungshalbleiterschalters (1) entgegengesetzt zu der gesteuerten unidirektionale Stromführungsrichtung des zweiten Leistungshalbleiterschalters (6) verläuft.

## Beschreibung

### Technisches Gebiet

Die Erfindung bezieht sich auf das Gebiet der Leistungselektronik und betrifft eine leistungselektronischen Schaltzelle, eine Umrichterschaltung mit solchen Schaltzellen und ein Verfahren zum Betreiben einer leistungselektronischen Schaltzelle.

### Stand der Technik

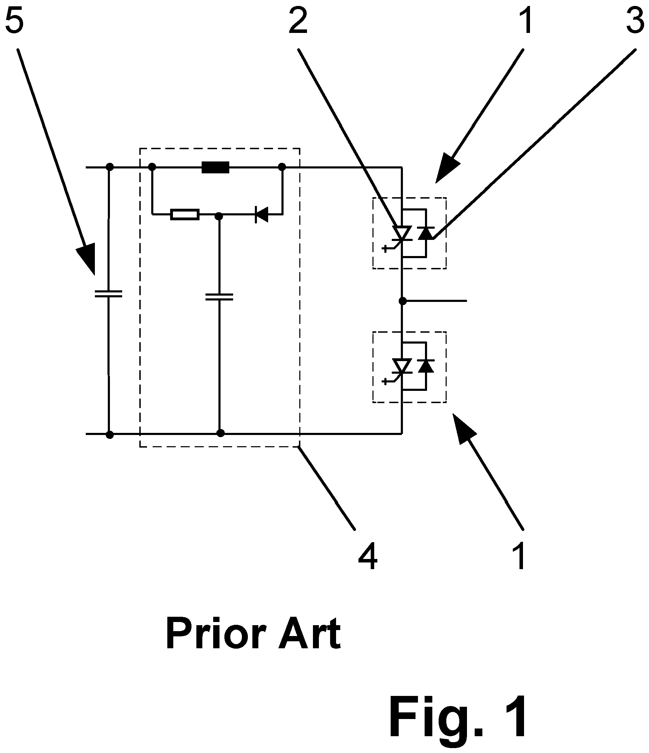

Umrichterschaltungen werden heute in einer Fülle von leistungselektronischen Anwendungen eingesetzt. Eine solche Umrichterschaltung weist je nach Einsatzgebiet und Applikation eine Vielzahl an Schaltzellen auf. Eine Schaltzelle umfasst typischerweise einen ansteuerbaren bidirektionale Leistungshalbleiterschalter mit gesteuerter unidirektionaler Stromführungsrichtung, wobei der einen ansteuerbaren bidirektionale Leistungshalbleiterschalter mit gesteuerter unidirektionaler Stromführungsrichtung durch einen Integrated-Gate-Commutated-Thyristoren bzw. integrierte Gate-kommutierte Thyristoren bzw. IGCT und durch eine diesem Thyristor antiparallel geschaltete Diode gebildet ist. IGCTs haben in der Regel sehr geringe Leitungsverluste und ermöglichen eine hohe Stromführung. Nichtsdestotrotz ist es erforderlich, ein Stromanstiegsbegrenzungsnetzwerk bzw. dl/dt-Netzwerk einzusetzen, um den IGCT und die Diode der Schaltzelle während des Schaltens zu schützen. Eine zu hohe Stromsteilheit dl/dt kann zu sehr hohen Stromspitzen der kommutierenden Diode während deren Sperrverzögerungszeit (reverse recovery time) und damit zu übermäßigen Verlusten führen, die die Diode aber auch den IGCT thermisch stark belasten oder gar zerstören können. Beispielhaft ist ein solches Stromanstiegsbegrenzungsnetzwerk für einen Umrichter zur Schaltung von zwei Schaltspannungsniveaus in einer Umrichterschaltung gemäss Fig. 1 dargestellt. Ein Stromanstiegsbegrenzungsnetzwerk gemäss Fig. 1 ist aber voluminös, schwer und entsprechend teuer.

Die US 2013/0 049 654 A1 betrifft einen Konverter mit einem Halbleiterschalter, zu dem ein Snubber-Schaltkreis mit einer Serienschaltung aus einem Halbleiterschalter, einem Widerstand und einem Kondensator parallel geschaltet ist.

Die DE 36 39 495 A1 betrifft einen Pulswechselrichter und zeigt einen Halbleiterschalter, zu dem ein Kondensator, ein Widerstand und eine weiterer Halbleiterschalter parallel geschaltet sind.

Die DE 10 2012 204 255 A1 zeigt einen Gleichspannungswandler, bei dem ein zweiter Schalter zusammen mit einem Widerstand und einem Kondensator parallel zu einem ersten Schalter verbaut sind.

Die EP 2 995 837 A1 zeigt ein Schaltelement mit einem Hilfsstrompfad, der weitere Schalter, einen Widerstand und einen Kondensator aufweist.

### Darstellung der Erfindung

Aufgabe der Erfindung ist es, eine leistungselektronische Schaltzelle anzugeben, welche ein Stromanstiegsbegrenzungsnetzwerk umfasst, das eine geringe Baugrösse und geringes Gewicht aufweist und damit kostengünstig ist. Desweiteren ist es eine Aufgabe der Erfindung, eine Umrichterschaltung anzugeben, welche mit solchen leistungselektronischen Schaltzellen realisiert werden kann.

Diese Aufgaben werden durch die Merkmale der unabhängigen Ansprüche gelöst. In den abhängigen Ansprüchen sind vorteilhafte Weiterbildungen der Erfindung angegeben.

Die erfindungsgemässe leistungselektronische Schaltzelle umfasst einen ersten ansteuerbaren bidirektionalen Leistungshalbleiterschalter mit gesteuerter unidirektionaler Stromführungsrichtung und ein Stromanstiegsbegrenzungsnetzwerk wobei der erste Leistungshalbleiterschalter eine erste Diode aufweist, die antiparallel zur gesteuerten unidirektionalen Stromführungsrichtung des ersten Leistungshalbleiterschalters angeordnet ist. Die erste Diode kann als Freilaufdiode des ersten bidirektionalen Leistungshalbleiterschalters aufgefasst werden.

Nach der Erfindung ist nun das Stromanstiegsbegrenzungsnetzwerk parallel zu dem ersten Leistungshalbleiterschalter geschaltet, wobei das Stromanstiegsbegrenzungsnetzwerk eine Serienschaltung aus einem zweiten ansteuerbaren bidirektionalen Leistungshalbleiterschalter mit gesteuerter unidirektionaler Stromführungsrichtung, einem Widerstand und einer Kapazität aufweist. Der zweite Leistungshalbleiterschalter weist eine zweite Diode auf, die antiparallel zur gesteuerten unidirektionalen Stromführungsrichtung des zweiten Leistungshalbleiterschalters angeordnet ist. Die zweite Diode kann als Freilaufdiode des zweiten bidirektionalen Leistungshalbleiterschalters aufgefasst werden.

Weiter ist der zweite Leistungshalbleiterschalter antiparallel zu dem ersten Leistungshalbleiterschalter angeordnet, so dass die gesteuerte unidirektionale Stromführungsrichtung des ersten Leistungshalbleiterschalters entgegengesetzt zu der gesteuerten unidirektionale Stromführungsrichtung des zweiten Leistungshalbleiterschalters verläuft.

Das vorstehend genannte und parallel zum ersten Leistungshalbleiterschalter geschaltete Stromanstiegsbegrenzungsnetzwerk der Schaltzelle ist sehr einfach aufgebaut und ausserdem platzsparend realisierbar. Darüber hinaus zeichnet sich die erfindungsgemässe Schaltzelle durch ein geringes Gewicht aus. Aufgrund all dieser vorteilhaften Eigenschaften ist die erfindungsgemässe Schaltzelle kostengünstig realisierbar. Zusätzlich können beim Schalten des ersten Leistungshalbleiterschalters unerwünschte und vor allem langanhaltende Spannungs- und Stromschwingungen mit hoher Amplitude im Hauptstrompfad der Schaltzelle durch das parallel zu dem ersten Leistungshalbleiterschalter geschaltete Stromanstiegsbegrenzungsnetzwerk vorteilhaft weitestgehend vermieden werden. Desweiteren lassen sich die Schaltzellen sehr einfach in Serie schalten.

Die erfindungsgemässe Umrichterschaltung umfasst einen Energiespeicherkreis, wobei mindestens zwei der vorstehend genannten erfindungsgemässen leistungselektronische Schaltzellen in Serie geschaltet sind und die Serienschaltung der mindestens zwei leistungselektronischen Schaltzellen mit dem Energiespeicherkreis verbunden ist. Die Umrichterschaltung mit den mindestens zwei leistungselektronischen Schaltzellen lässt sich damit äusserst einfach und schnell aufbauen, weist eine geringe Schaltungskomplexität auf, ist aus diesem Grund sehr robust, wartungsfreundlich und zeichnet sich durch eine hohe Verfügbarkeit aus.

Ein Verfahren zum Betreiben einer leistungselektronischen Schaltzelle, wie sie obenstehend und untenstehend beschrieben ist, umfasst: Schalten des zweiten Leistungshalbleiterschalters derart, dass die Kapazität über den Widerstand entgegengesetzt zur unidirektionalen Stromführungsrichtung des erste Leistungshalbleiterschalter geladen wird; und Reduzieren einer am erste Leistungshalbleiterschalter auftretenden Spannungsspitze, die durch Schalten des erste Leistungshalbleiterschalter erzeugt wird, mit der entgegengesetzt geladenen Kapazität. Die Kapazität kann entgegengesetzt zur Schaltrichtung des ersten Leistungshalbleiterschalters aufgeladen werden. Die an der Kapazität anliegende Spannung kann dann dazu genutzt werden, am ersten Leistungshalbleiterschalter auftretende Spannungsspitzen mit entgegengesetzter Spannung zu reduzieren.

Diese und weitere Aufgaben, Vorteile und Merkmale der vorliegenden Erfindung werden aus der nachfolgenden detaillierten Beschreibung bevorzugter Ausführungsformen der Erfindung in Verbindung mit der Zeichnung offensichtlich.

### Kurze Beschreibung der Zeichnungen

Es zeigen:
- Fig. 1: eine Ausführungsform einer Umrichterschaltung mit einem Stromanstiegsbegrenzungsnetzwerk nach dem Stand der Technik,
- Fig. 2: eine erste Ausführungsform einer erfindungsgemässen leistungselektronischen Schaltzelle,
- Fig. 2a: Strom- und Spannungsverläufe an einer leistungselektronischen Schaltzelle gemäss Fig. 2,
- Fig. 3: eine zweite Ausführungsform einer erfindungsgemässen leistungselektronischen Schaltzelle,
- Fig. 3a: Strom- und Spannungsverläufe an einer leistungselektronischen Schaltzelle gemäss Fig. 3,
- Fig. 4: eine erste Ausführungsform einer erfindungsgemässen Umrichterschaltung,
- Fig. 5: eine zweite Ausführungsform einer erfindungsgemässen Umrichterschaltung,
- Fig. 6: eine dritte Ausführungsform einer erfindungsgemässen Umrichterschaltung und
- Fig. 7: eine vierte Ausführungsform einer erfindungsgemässen Umrichterschaltung.

Die in den Figuren verwendeten Bezugszeichen und deren Bedeutung sind in der Bezugszeichenliste zusammengefasst aufgelistet. Grundsätzlich sind in den Figuren gleiche Teile mit gleichen Bezugszeichen versehen. Die beschriebenen Ausführungsformen stehen beispielhaft für den Erfindungsgegenstand und haben keine beschränkende Wirkung.

### Wege zur Ausführung der Erfindung

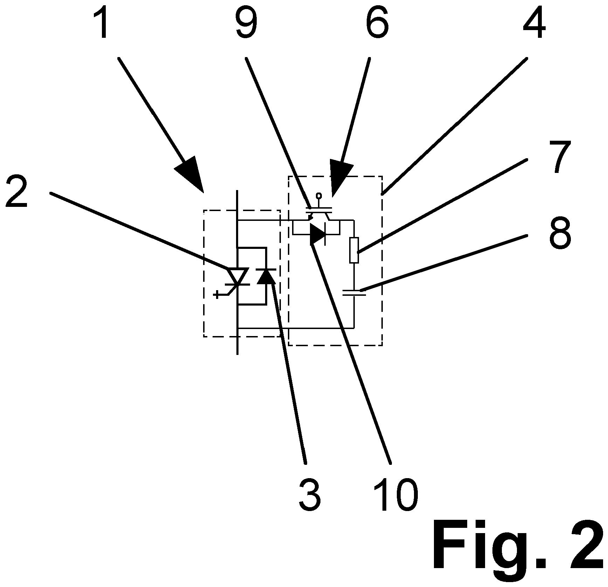

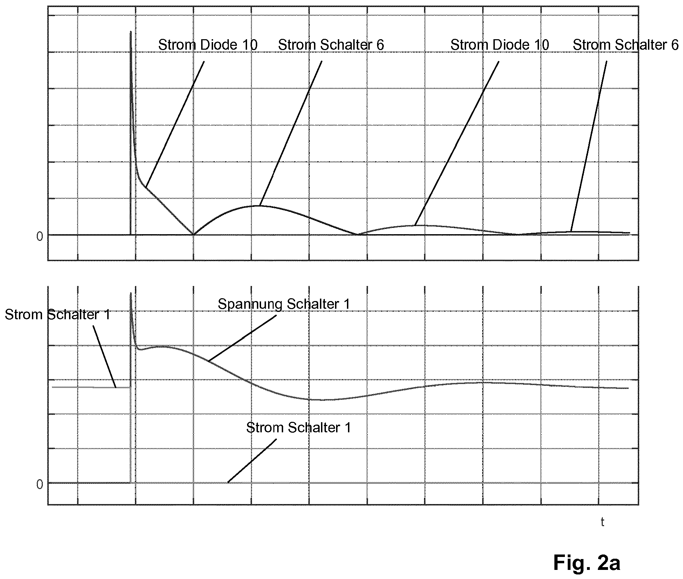

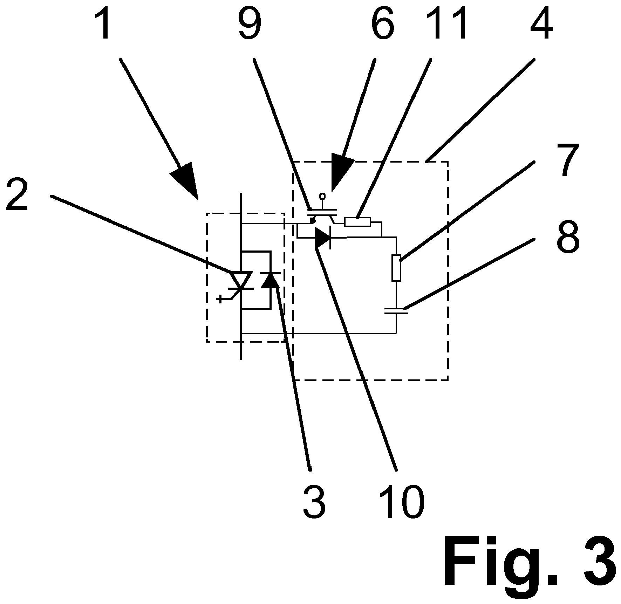

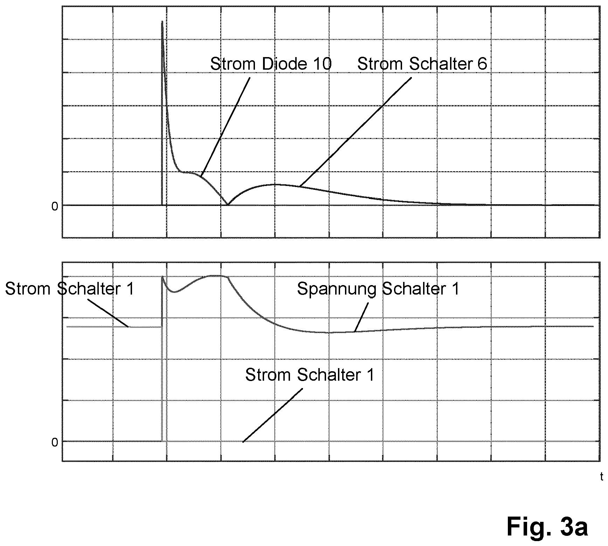

In Fig. 1 ist die bereits eingangs erwähnte Ausführungsform einer Umrichterschaltung mit einem Stromanstiegsbegrenzungsnetzwerk nach dem Stand der Technik gezeigt. In Fig. 2 ist nun eine erste Ausführungsform einer erfindungsgemässen leistungselektronischen Schaltzelle dargestellt. Ferner zeigt Fig. 3 eine zweite Ausführungsform einer erfindungsgemässen leistungselektronischen Schaltzelle. Allgemein umfasst die erfindungsgemässe leistungselektronische Schaltzelle einen ersten ansteuerbaren bidirektionalen Leistungshalbleiterschalter 1 mit gesteuerter unidirektionaler Stromführungsrichtung und ein Stromanstiegsbegrenzungsnetzwerk 4. Wie in Fig. 2 und Fig. 3 beispielhaft gezeigt, ist das Stromanstiegsbegrenzungsnetzwerk 4 parallel zu dem ersten Leistungshalbleiterschalter 1 geschaltet, wobei das Stromanstiegsbegrenzungsnetzwerk 4 eine Serienschaltung aus einem zweiten ansteuerbaren bidirektionalen Leistungshalbleiterschalter 6 mit gesteuerter unidirektionaler Stromführungsrichtung, einem Widerstand 7 und einer Kapazität 8 aufweist. Das vorstehend genannte und parallel zum ersten Leistungshalbleiterschalter geschaltete Stromanstiegsbegrenzungsnetzwerk der Schaltzelle ist denkbar einfach aufgebaut, platzsparend realisiert, weist ein geringes Gewicht auf und ist insgesamt somit kostengünstig realisierbar. Ferner können beim Schalten des ersten Leistungshalbleiterschalters 1 unerwünschte und vor allem langanhaltende Spannungs- und Stromschwingungen mit hoher Amplitude im Hauptstrompfad der Schaltzelle durch das parallel zu dem ersten Leistungshalbleiterschalter geschaltete Stromanstiegsbegrenzungsnetzwerk vorteilhaft weitestgehend vermieden werden.

Vorzugsweise weist der erste Leistungshalbleiterschalter 1 einen integrierten Gate-kommutierten Thyristor 2 (Integrated-Gate-Commutated-Thyristor IGCT) und eine dazu antiparallel geschaltete Diode 3 auf. Alternativ kann der erste Leistungshalbleiterschalter 1 auch einen Bipolartransistor mit isoliert angeordneter Ansteuerelektrode (Insulated-Gate Bipolar Transistor IGBT) und eine dazu antiparallel geschaltete Diode 3 aufweisen. Eine weitere Alternative ist, dass der erste Leistungshalbleiterschalter 1 einen Gate-Turn-OFF-Thyristor und eine dazu antiparallel geschaltete Diode 3 aufweist. Darüber hinaus ist es auch denkbar, dass der erste Leistungshalbleiterschalter 1 einen Leistungs-Metall-Oxid-Halbleiter-Feldeffekttransistor und eine dazu antiparallel geschaltete Diode 3 aufweist.

Der zweite ansteuerbare bidirektionale Leistungshalbleiterschalter 6 weist vorzugsweise einen Bipolartransistor mit isoliert angeordneter Ansteuerelektrode 9 und eine dazu antiparallel geschaltete Diode 10 auf. Als Alternative dazu ist es auch möglich, dass der zweite ansteuerbare bidirektionale Leistungshalbleiterschalter 6 einen Leistungs-Metall-Oxid-Halbleiter-Feldeffekttransistor und eine dazu antiparallel geschaltete Diode 10 aufweist.

In Fig. 2a sind Strom- und Spannungsverläufe an der leistungselektronischen Schaltzelle gemäss Fig. 2 dargestellt. Das untere Teilbild von Fig. 2a zeigt den Übergang des ersten Leistungshalbleiterschalters 1 vom Einschaltzustand in den Ausschaltzustand, d.h. den Spannungsverlauf des ersten Leistungshalbleiterschalters 1 und den Stromverlauf des ersten Leistungshalbleiterschalters 1. Das obere Teilbild von Fig. 2a zeigt den diesbezüglichen Stromverlauf am zweiten Leistungshalbleiterschalter 6 und an der Diode 10. Die schaltspezifische äusserst kurze Spannungsspitze des ersten Leistungshalbleiterschalters 1 im unteren Teilbild von Fig. 2a fällt bezüglich deren Amplitude aufgrund der Wirkungsweise des Stromanstiegsbegrenzungsnetzwerks 4 gemäss Fig. 2 vorteilhaft sehr moderat aus, so dass der erste Leistungshalbleiterschalter 1 dadurch nur wenig belastet wird.

In der zweiten Ausführungsform der erfindungsgemässen leistungselektronischen Schaltzelle gemäss Fig. 3 weist der zweite ansteuerbare bidirektionale Leistungshalbleiterschalter 6 eine Serienschaltung eines Bipolartransistors mit isoliert angeordneter Ansteuerelektrode 9 und eines Widerstandes 11 und eine zu der Serienschaltung des Bipolartransistors mit isoliert angeordneter Ansteuerelektrode 9 und des Widerstandes 11 antiparallel geschaltete Diode 10 auf. Alternativ dazu ist es auch denkbar, dass der zweite ansteuerbare bidirektionale Leistungshalbleiterschalter 6 eine Serienschaltung eines Leistungs-Metall-Oxid-Halbleiter-Feldeffekttransistors und eines Widerstandes 11 und eine zu der Serienschaltung des Leistungs-Metall-Oxid-Halbleiter-Feldeffekttransistors und des Widerstandes 11 antiparallel geschaltete Diode 10 aufweist.

In Fig. 3a sind Strom- und Spannungsverläufe an der leistungselektronischen Schaltzelle gemäss Fig. 3 dargestellt. Das untere Teilbild von Fig. 3a zeigt den Übergang des ersten Leistungshalbleiterschalters 1 vom Einschaltzustand in den Ausschaltzustand, d.h. den Spannungsverlauf des ersten Leistungshalbleiterschalters 1 und den Stromverlauf des ersten Leistungshalbleiterschalters 1. Das obere Teilbild von Fig. 3a zeigt den diesbezüglichen Stromverlauf am zweiten Leistungshalbleiterschalter 6 und an der Diode 10. Die schaltspezifische Spannungsspitze des ersten Leistungshalbleiterschalters 1 im unteren Teilbild von Fig. 3a ist gegenüber Fig. 2a bezüglich der Amplitude signifikant verringert, was auf der Wirkungsweise des Stromanstiegsbegrenzungsnetzwerks 4 gemäss Fig. 3, insbesondere auf die Kombination der Widerstände 7 und 11 zurückzuführen ist. Mit Vorteil kann dadurch die Belastung des ersten Leistungshalbleiterschalter 1 weiter verringert werden.

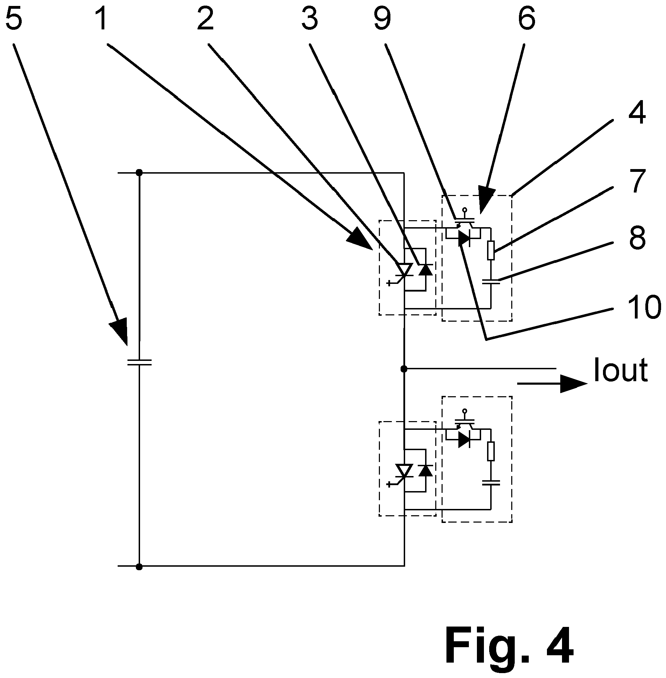

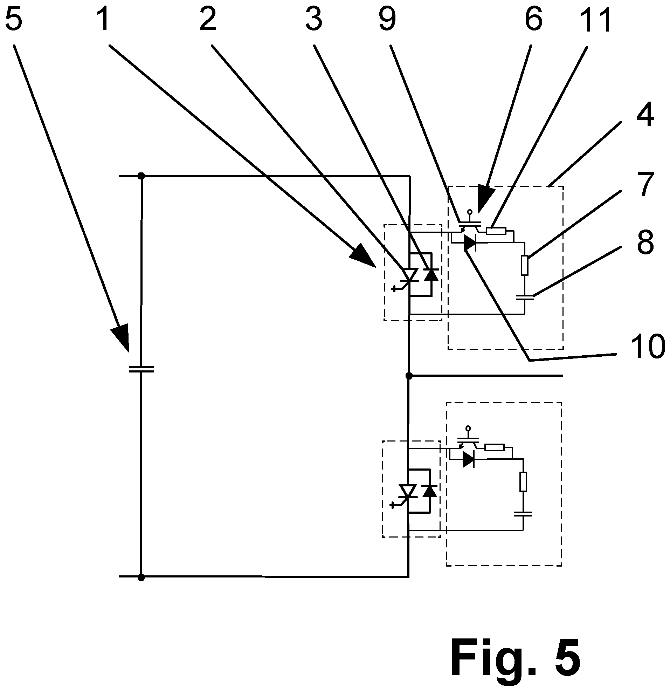

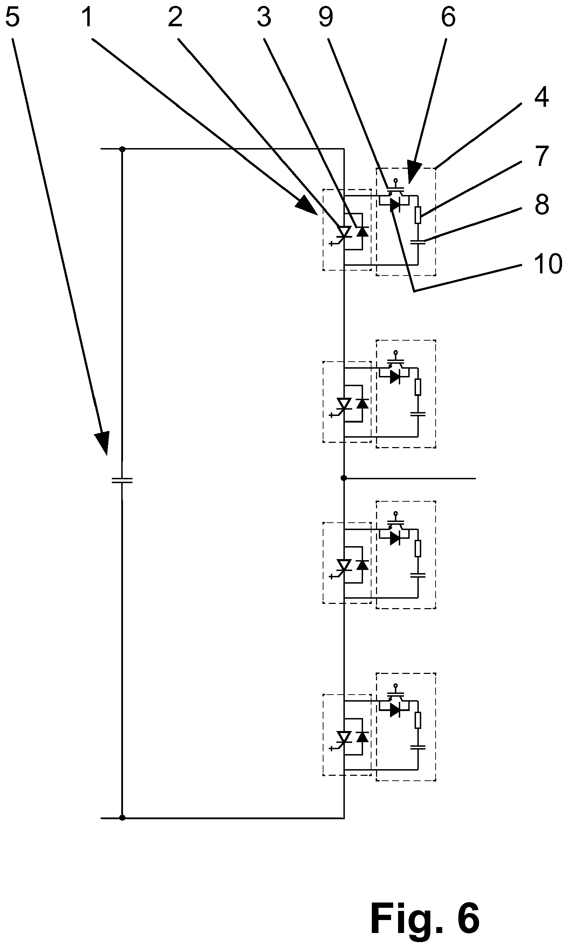

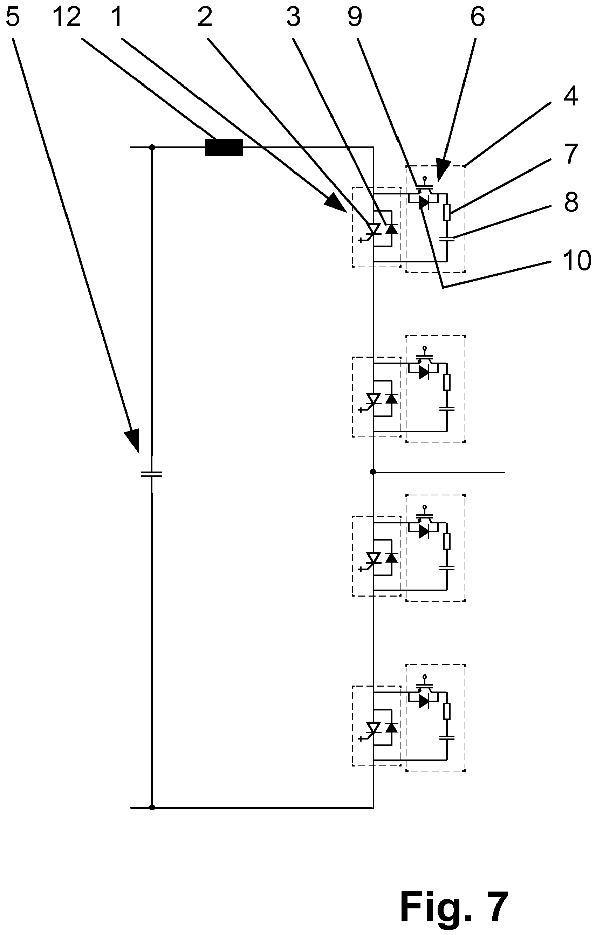

In Fig. 4 ist eine erste Ausführungsform einer erfindungsgemässen Umrichterschaltung gezeigt, welche leistungselektronische Schaltzellen gemäss Fig. 2 aufweist. In einer zweite Ausführungsform einer erfindungsgemässen Umrichterschaltung gemäss Fig. 5 sind leistungselektronische Schaltzellen gemäss Fig. 3 verwendet. Eine dritte Ausführungsform einer erfindungsgemässen Umrichterschaltung nach Fig. 6 und eine vierte Ausführungsform einer erfindungsgemässen Umrichterschaltung nach Fig. 7 umfasst jeweils leistungselektronische Schaltzellen gemäss Fig. 2.

Allgemein umfasst die erfindungsgemässe Umrichterschaltung einen Energiespeicherkreis 5, wie beispielhaft in Fig. 4 bis Fig. 7 dargestellt. Gemäss Fig. 4 bis Fig. 7 umfasst der Energiespeicherkreis 5 eine Kapazität, wobei auch mehrere Kapazitäten in verschiedensten Verschaltungsvarianten denkbar sind. Desweiteren umfasst die erfindungsgemässe Umrichterschaltung allgemein mindestens zwei vorstehend detailliert beschriebene erfindungsgemässe leistungselektronische Schaltzellen, die in Serie geschaltet sind, wobei die Serienschaltung der mindestens zwei leistungselektronischen Schaltzellen dann mit dem Energiespeicherkreis 5 verbunden ist.

Bei der Serienschaltung der mindestens zwei leistungselektronischen Schaltzellen bildet ein Verbindungspunkt zwischen zwei Schaltzellen vorteilhaft einen Wechselspannungsanschluss.

Nachfolgend wird das Schaltverhalten der Schaltzellen der Umrichterschaltung nach Fig. 4 näher beschrieben. Es sei explizit erwähnt, dass der Ausgangsstrom lout über den vorstehend genannten Wechselspannungsanschluss gemäss der in Fig. 4 dargestellten Zählpfeilrichtung als "positiver" Ausgangsstrom lout definiert ist.

### 1. Positiver Ausgangsstrom lout:

### Ausschalten:

Der IGCT 2 der oberen Schaltzelle ist zunächst eingeschaltet und Strom fliesst durch den IGCT 2 der oberen Schaltzelle. Der IGCT 2 der unteren Schaltzelle und der IGBT 9 der unteren Schaltzelle sind ausgeschaltet. Dann wird der IGCT 2 der oberen Schaltzelle ausgeschaltet und der IGBT 9 der oberen Schaltzelle eingeschaltet. Sobald der IGCT 2 der oberen Schaltzelle ausgeschaltet wird, kommutiert der Strom über die Diode 10 der oberen Schaltzelle an die Kapazität 8 der oberen Schaltzelle. Aufgrund des Spannungsabfalls am Widerstand 7 der oberen Schaltzelle kommutiert der Strom schließlich auf die Diode 3 der unteren Schaltzelle, wobei die Kapazität 8 der oberen Schaltzelle nicht vollständig entladen wird. Schließlich wird der IGCT 2 der unteren Schaltzelle nach einer Einschaltverzögerung eingeschaltet. Der IGBT9 der oberen Schaltzelle kann bis zu nächsten Kommutierung eingeschaltet bleiben.

### Einschalten:

Der Strom fliesst zunächst durch die Diode 3 der unteren Schaltzelle. Der IGCT 2 der oberen Schaltzelle und der IGBT 9 der oberen Schaltzelle sind ausgeschaltet. Dann wird der IGCT 2 der unteren Schaltzelle ausgeschaltet und der IGBT 9 der unteren Schaltzelle eingeschaltet. Der Strom kommutiert von die Diode 10 der unteren Schaltzelle über den IGBT 9 der unteren Schaltzelle an die Kapazität 8 der unteren Schaltzelle. Schließlich wird der IGCT 2 der oberen Schaltzelle nach einer Einschaltverzögerung eingeschaltet.

### 2. Negativer Ausgangsstrom lout:

### Ausschalten:

Der Strom fliesst zunächst durch die Diode 3 der oberen Schaltzelle. Der IGCT 2 der unteren Schaltzelle und der IGBT 9 der unteren Schaltzelle sind ausgeschaltet. Dann wird der IGCT 2 der oberen Schaltzelle ausgeschaltet und der IGBT 9 der oberen Schaltzelle eingeschaltet. Der Strom kommutiert von die Diode 10 der oberen Schaltzelle über den IGBT 9 der oberen Schaltzelle an die Kapazität 8 der oberen Schaltzelle. Schließlich wird der IGCT 2 der unteren Schaltzelle nach einer Einschaltverzögerung eingeschaltet.

### Einschalten:

Der IGCT 2 der unteren Schaltzelle ist zunächst eingeschaltet und Strom fliesst durch den IGCT 2 der unteren Schaltzelle. Der IGCT 2 der oberen Schaltzelle und der IGBT 9 der oberen Schaltzelle sind ausgeschaltet. Dann wird der IGCT 2 der unteren Schaltzelle ausgeschaltet und der IGBT 9 der unteren Schaltzelle eingeschaltet. Sobald der IGCT 2 der unteren Schaltzelle ausgeschaltet wird, kommutiert der Strom über die Diode 10 der unteren Schaltzelle an die Kapazität 8 der unteren Schaltzelle. Aufgrund des Spannungsabfalls am Widerstand 7 der unteren Schaltzelle kommutiert der Strom schließlich auf die Diode 3 der oberen Schaltzelle, wobei die Kapazität 8 der unteren Schaltzelle nicht vollständig entladen wird. Schließlich wird der IGCT 2 der oberen Schaltzelle nach einer Einschaltverzögerung eingeschaltet. Der IGBT 9 der unteren Schaltzelle kann bis zu nächsten Kommutierung eingeschaltet bleiben.

Wie beispielhaft in der vierten Ausführungsform der erfindungsgemässen Umrichterschaltung gemäss Fig. 7 gezeigt, kann allgemein eine Induktivität 12 in Serie zur Serienschaltung der mindestens zwei leistungselektronischen Schaltzellen geschaltet sein. Vorzugsweise sind die Induktivität 12 und die Serienschaltung der mindestens zwei leistungselektronischen Schaltzellen mit dem Energiespeicherkreis 5 verbunden. Denkbar ist es aber auch, dass die Induktivität 12 mitten in die Serienschaltung der mindestens zwei leistungselektronischen Schaltzellen eingeschaltet ist. Die Induktivität 12 dient dem Schutz der Schaltzellen und/oder der Strombegrenzung beispielsweise im Falle eines Kurzschlusses oder sonstigen Fehlerfalls einer Schaltzelle. Desweiteren lassen sich Schaltverluste der Schalter 9 der einzelnen Schaltzellen mittels der Induktivität 12 vorteilhaft verringern, da diese strombegrenzend wirkt.

### Bezugszeichenliste

- 1: erster ansteuerbarer bidirektionaler Leistungshalbleiterschalter
- 2: integrierte Gate-kommutierter Thyristor
- 3: Diode
- 4: Stromanstiegsbegrenzungsnetzwerk
- 5: Energiespeicherkreis
- 6: zweiter ansteuerbarer bidirektionaler Leistungshalbleiterschalter
- 7: Widerstand
- 8: Kapazität
- 9: Bipolartransistor mit isoliert angeordneter Ansteuerelektrode
- 10: Diode
- 11: Widerstand
- 12: Induktivität

## Patentansprüche

1. Leistungselektronische Schaltzelle, mit einem ersten ansteuerbaren bidirektionalen Leistungshalbleiterschalter (1) mit gesteuerter unidirektionaler Stromführungsrichtung,
und mit einem Stromanstiegsbegrenzungsnetzwerk (4),
wobei der erste Leistungshalbleiterschalter (1) eine erste Diode (3) aufweist, die antiparallel zur gesteuerten unidirektionalen Stromführungsrichtung des ersten Leistungshalbleiterschalters (1) angeordnet ist,
wobei das Stromanstiegsbegrenzungsnetzwerk (4) parallel zu dem ersten Leistungshalbleiterschalter (1) geschaltet ist,
wobei das Stromanstiegsbegrenzungsnetzwerk (4) eine Serienschaltung aus einem zweiten ansteuerbaren bidirektionalen Leistungshalbleiterschalter (6) mit gesteuerter unidirektionaler Stromführungsrichtung, einem Widerstand (7) und einer Kapazität (8) aufweist,
wobei der zweite Leistungshalbleiterschalter (6) eine zweite Diode (10) aufweist, die antiparallel zur gesteuerten unidirektionalen Stromführungsrichtung des zweiten Leistungshalbleiterschalters (6) angeordnet ist,
wobei der zweite Leistungshalbleiterschalter (6) antiparallel zu dem ersten Leistungshalbleiterschalter (1) angeordnet ist, so dass die gesteuerte unidirektionale Stromführungsrichtung des ersten Leistungshalbleiterschalters (1) entgegengesetzt zu der gesteuerten unidirektionale Stromführungsrichtung des zweiten Leistungshalbleiterschalters (6) verläuft.

2. Leistungselektronische Schaltzelle nach Anspruch 1, **dadurch gekennzeichnet, dass** der erste Leistungshalbleiterschalter (1) einen integrierten Gate-kommutierten Thyristor (2) und die dazu antiparallel geschaltete erste Diode (3) aufweist.

3. Leistungselektronische Schaltzelle nach Anspruch 1, **dadurch gekennzeichnet, dass** der erste Leistungshalbleiterschalter (1) einen Bipolartransistor mit isoliert angeordneter Ansteuerelektrode und die dazu antiparallel geschaltete erste Diode (3) aufweist.

4. Leistungselektronische Schaltzelle nach Anspruch 1, **dadurch gekennzeichnet, dass** der erste Leistungshalbleiterschalter (1) einen Gate-Turn-OFF-Thyristor und die dazu antiparallel geschaltete erste Diode (3) aufweist.

5. Leistungselektronische Schaltzelle nach Anspruch 1, **dadurch gekennzeichnet, dass** der erste Leistungshalbleiterschalter (1) einen Leistungs-Metall-Oxid-Halbleiter-Feldeffekttransistor und die dazu antiparallel geschaltete erste Diode (3) aufweist.

6. Leistungselektronische Schaltzelle nach einem der Ansprüche 1 bis 5, **dadurch gekennzeichnet, dass** der zweite ansteuerbare bidirektionale Leistungshalbleiterschalter (6) einen Bipolartransistor mit isoliert angeordneter Ansteuerelektrode (9) und die dazu antiparallel geschaltete zweite Diode (10) aufweist.

7. Leistungselektronische Schaltzelle nach einem der Ansprüche 1 bis 5, **dadurch gekennzeichnet, dass** der zweite ansteuerbare bidirektionale Leistungshalbleiterschalter (6) einen Leistungs-Metall-Oxid-Halbleiter-Feldeffekttransistor und die dazu antiparallel geschaltete zweite Diode (10) aufweist.

8. Leistungselektronische Schaltzelle nach einem der Ansprüche 1 bis 5, **dadurch gekennzeichnet, dass** der zweite ansteuerbare bidirektionale Leistungshalbleiterschalter (6) eine Serienschaltung eines Bipolartransistors mit isoliert angeordneter Ansteuerelektrode (9) und eines Widerstandes (11) und der zu der Serienschaltung des Bipolartransistors mit isoliert angeordneter Ansteuerelektrode (9) und des Widerstandes (11) antiparallel geschalteten zweiten Diode (10) aufweist.

9. Leistungselektronische Schaltzelle nach einem der Ansprüche 1 bis 5, **dadurch gekennzeichnet, dass** der zweite ansteuerbare bidirektionale Leistungshalbleiterschalter (6) eine Serienschaltung eines Leistungs-Metall-Oxid-Halbleiter-Feldeffekttransistors und eines Widerstandes (11) und der zu der Serienschaltung des Leistungs-Metall-Oxid-Halbleiter-Feldeffekttransistors und des Widerstandes (11) antiparallel geschalteten zweiten Diode (10) aufweist.

10. Umrichterschaltung mit einem Energiespeicherkreis (5), **dadurch gekennzeichnet,**
**dass** mindestens zwei leistungselektronische Schaltzellen gemäss einem der Ansprüche 1 bis 9 in Serie geschaltet sind, und
**dass** die Serienschaltung der mindestens zwei leistungselektronischen Schaltzellen mit dem Energiespeicherkreis (5) verbunden ist.

11. Umrichterschaltung nach Anspruch 10, **dadurch gekennzeichnet, dass** bei der Serienschaltung der mindestens zwei leistungselektronischen Schaltzellen ein Verbindungspunkt zwischen zwei Schaltzellen einen Wechselspannungsanschluss bildet.

12. Umrichterschaltung nach Anspruch 10 oder 11, **dadurch gekennzeichnet, dass** eine Induktivität (12) in Serie zur Serienschaltung der mindestens zwei leistungselektronischen Schaltzellen geschaltet ist.

13. Umrichterschaltung nach Anspruch 12, **dadurch gekennzeichnet, dass** die Induktivität (12) und die Serienschaltung der mindestens zwei leistungselektronischen Schaltzellen mit dem Energiespeicherkreis (5) verbunden ist.

14. Verfahren zum Betreiben einer leistungselektronische Schaltzelle nach einem der Ansprüche 1 bis 9, das Verfahren umfassend:
Schalten des zweiten Leistungshalbleiterschalters (6) derart, dass die Kapazität (8) über den Widerstand (7) entgegengesetzt zur unidirektionalen Stromführungsrichtung des erste Leistungshalbleiterschalter (1) geladen wird;
Reduzieren einer am erste Leistungshalbleiterschalter (1) auftretenden Spannungsspitze, die durch Schalten des erste Leistungshalbleiterschalter (1) erzeugt wird, mit der entgegengesetzt geladenen Kapazität (8).
